# EUROPEAN PATENT APPLICATION

(11) **EP 3 355 338 A1**
(43) Date of publication of application: **01.08.2018**
(21) Application number: 17207131.8
(22) Date of filing: 13.12.2017
(51) Int. Cl.: H01J 37/32, C23C 14/28, C23C 14/32, H01J 37/34

(54) **APPARATUS AND METHOD FOR SURFACE PROCESSING**

(30) Priority: 25.01.2017 CH 802017; 24.04.2017 EP 17167826
(71) Applicant: Mikhailov, Sergueï, 2014 Bôle (CH)
(72) Inventor: Mikhailov, Sergueï, 2014 Bôle (CH)
(74) Representative: P&TS SA (AG, Ltd.)

(57) **Abstract**

An apparatus for coating parts, comprising a deposition chamber (1) and a plurality of coating equipment (2, 3) for simultaneously or successively providing coating materials to said deposition chamber, wherein at least one of said coating equipment (2) is a metal filtered arc ion source, at least one other of said coating equipment (3) is a laser ablation source, and at least two of said coating equipment are removably connected to said deposition chamber via connecting flanges (10). At least two of said flanges are identical, so that one said coating equipment (2, 3) can be connected via different flanges to said deposition chamber.

## Description

### Field of the invention

The present invention concerns an apparatus and a method for coating parts, especially an apparatus which generates a plasma of various coating materials for deposition on surfaces of parts to be coated. This coating apparatus can be used, without limitation, in the coating and hardening of tools, instruments, electronic components, goods including watches and glasses, etc.

### Description of related art

Various methods and apparatus are known for coating and hardening parts. Conventional physical vapour deposition (PVD) methods use a cathode and an anode. Application of an electric field between the cathode and the anode evaporates material from the cathode, which forms a beam that can be deflected and filtered to reach a vacuum deposition chamber where the parts to coat are placed. The evaporated material from the anode deposits on the parts within the deposition chamber, which are progressively coated with this material.

An example of PVD devices using a metal filtered arc ion source is described in US6663755. In order to increase the rate of deposition, this apparatus uses two plasma sources that generate two plasma flows directed toward the same deposition chamber. Since the two sources are directed toward each other, a conductive shield is required to serve as a baffle for preventing the plasma flow generated by one plasma source to reach the other plasma source. This baffle increases the cost and volume of the equipment, and needs to be cleaned or even replaced periodically. Moreover, the quality of the filtration could be improved; ion particles of different sizes reach the target, producing uneven coatings.

Similar machines for coating parts with a metal filtered arc ion source are disclosed in WO2007089216 and in WO2007136777.

Laser ablation devices have also been used for coating parts; they generally utilize a pulsed laser source directed toward the material to be ablated, such as a bloc of carbon material. The laser pulses produce ablation of material, which is projected and possibly deflected toward the parts within the deposition chamber.

An example of laser ablation equipment is described in US5747120. In this document, the target that is ablated with the laser is placed right in the chamber. This setting makes replacement of the target difficult, especially if the chamber is maintained at vacuum conditions. Moreover, the parts to be coated are placed in a small volume outside of the main chamber, so that only a limited number of parts can be coated at the same time.

Another laser ablation system is disclosed in US6372103. In this document, a laser outside of the deposition chamber generates a laser beam that crosses a window and reaches a cylindrical target rotating within the deposition chamber. Again, replacement of the target requires opening of the whole deposition chamber, which can be time-consuming and expensive if the chamber is at vacuum conditions. Moreover, the laser beam makes a perpendicular angle with the surface of the rotating target, so that at least a part of the ablated material bounces against the window, whose inner side is rapidly covered and needs cleaning to keep its transparency.

Other example of laser arc system for carbon deposition are disclosed in US6231956.

Some parts require sophisticated coatings with different layers of different materials; the manufacturing process typically utilizes different steps performed in different deposition chambers in order to deposit the different layers successively. This is an expensive method, since it requires multiple deposition chambers with associated vacuum pumps or vacuum generating devices, etc. Moreover, the manufacturing throughput is reduced since the parts needs to be transferred from one deposition chamber to the next; vacuum often needs to be re-generated after each transfer.

WO2008015016 describes an apparatus for the coating of substrates with diamond-like layers, in which different coating equipment of different types are arranged toward a common deposition chamber, or in line each in a separate chamber. This allows coating of large number of parts within a single batch process, and without any need to open the deposition chamber between depositions of two different layers with source equipment of different types.

An aim of the present invention is to increase the flexibility of the apparatus and methods described in WO2008015016.

Another aim is to allow coating and manufacturing of different parts, with different layers, without replacing the whole apparatus.

Several important application demand the deposition of coatings with a highly smooth finish. The device and the method of the present invention can produce protection and anti-friction coatings possessing a very low level of surface roughness.

### Brief summary of the invention

According to the invention, these aims are achieved by means of an apparatus for coating parts, comprising a deposition chamber and a plurality of coating equipment for simultaneously or successively providing coating materials to said deposition chamber, wherein at least one of said coating equipment is a metal filtered arc ion source followed by a magnetic and/or electrostatic macro particle filter, at least one other of said coating equipment is an equipment selected among a filtered arc carbon source with laser ignition, a magnetron, a CVD equipment, or a low energy ion gun, at least two of said coating equipment are removably connected to said deposition chamber via connecting flanges, at least two of said flanges are identical, so that one said coating equipment can be connected via different flanges to said deposition chamber.

The combination of metal arc sources and/or arc-carbon, laser-triggered sources with magnetic and electrostatic macro particle filters including paired coils and electrostatic deflectors removes high-mass clusters form the deposition beam providing superior surface smoothness.

The use of similar or identical flanges for connecting different source equipment of different types to a common deposition chamber is advantageous since it allows easy replacement of one coating equipment of one type by a coating equipment of any other type. The coating equipment around the common chambers are thus entirely interchangeable. For example, one part may requires one metal filtered arc ion source equipment for metal deposition, and one laser ablation source for carbon deposition, while another part will use two metal filtered arc ion source equipment for faster deposition of one layer, or for deposition of two different metals in two successive layers.

Conventional apparatus having similar flanges for different equipment may be existing, but each of the flange is nevertheless specifically adapted for a particular equipment, which are not interchangeable and can't be mounted at any position or on any flange.

According to another, possibly independent aspect, the apparatus for coating parts comprises a deposition chamber and at least one metal filtered arc ion source with at least one pair of metal ion sources, each metal ion source having at least one cathode, at least one anode and associated coils, wherein the angle between the emission directions of the two sources within each said pair is larger than 90° but lower than 175°.

The angle lower than 175° avoids the risk that each source emits material in the direction of the other source, and removes the need for a shield between the two sources. The angle between the emission directions of the two sources within each said pair may be larger than 90° but lower than 135°. Having an angle between the two sources larger than 90°, and preferably lower than 135°, allows for an important deflection angle toward the parts to be coated, and ensure efficient filtering of the flows.

In one embodiment, the directions of emissions of the two sources within each pair are not in a same plane. This allows a better spreading of the two flows within the deposition chamber, and a more homogeneous coating.

The metal ion source preferably each comprise two focusing coils for focusing the metal ion beam. A common deflection system comprises one first coil traversed by the metal ion beam produced by each of the metal ion sources, and one second coil behind said metal ion source, both coils cooperating for deflecting said metal ion beam toward said deposition chamber. This allows efficient deflection with a limited number of coils.

According to another, possibly independent aspect, the apparatus for coating parts comprises a laser ablation equipment with a laser, a mirror for deflecting the laser beam produced by said laser toward a target, a first motor for rotating said target, and a second motor for displacing said mirror so as to ablate different portions of said target. A third motor can be used for displacing the target relatively to said laser beam along an axis parallel to the rotation axis of the target. The second and third motor allows use of very large targets from which different parts are successively ablated, and increase the duration of the period between successive replacements of a target.

According to another, possibly independent aspect, the apparatus for coating parts comprises a laser ablation equipment in which a laser beam is directed so as to make an angle with the target which is lower than an angle between the laser beam and a tangent of the target. This reduces the risk that ablated material bounces toward the entry window, and cancels the requirement for cleaning this window.

Faster coating can be achieved with the use in one source equipment of two lasers for ablating the same target, or for ablating two different targets.

### Brief Description of the Drawings

The invention will be better understood with the aid of the description of an embodiment given by way of example and illustrated by Fig. 1 that shows a sectional view of the apparatus of the invention, figure 2 that shows a detail of the laser-arc source, figure 3 illustrating a voltage bias circuit, and figure 4 that is a chronogram of a typical discharge in the laser arc source.

### Detailed Description of possible embodiments of the Invention

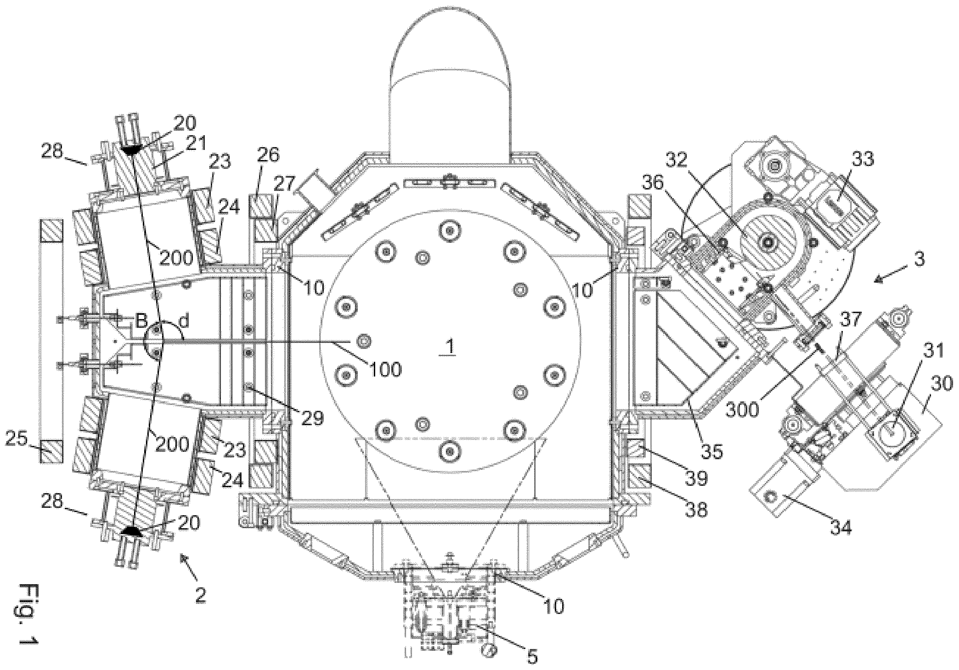

Fig. 1 shows an apparatus according to the invention which has a single deposition chamber 1. Parts to be coated (not shown), such as substrates, drills, mechanical parts and so on, are placed on one or several part holders in the deposition chamber 1. Depending on the application, vacuum can be applied to the deposition chamber 1 using a vacuum generation system (not shown).

The deposition chamber 1 comprises a plurality of connecting flanges 10 for connecting various coating equipment. In the present document, the expression "coating equipment" generally designates equipment that can be used as a source for generating a flow of material directed toward the deposition chamber 1, in order to coat the parts within this chamber. According to an aspect of the invention, at least two connecting flanges 10 are identical or at least compatible, so that one equipment can equivalently be connected to one flange or to the other.

In the illustrated example, the deposition chamber 1 has two identical connecting flanges 10, although more than two flanges could be used. The flanges are preferably vacuum flanges. A first coating equipment, in the form of a metal filtered arc ion source 2, is connected to one of the connecting flanges 10, while a second coating equipment, in the form of a laser ablation source 3, is connected to the other connecting flange 10 of the illustrated example. Since the apparatus has two compatible connecting flanges 10, it would also be possible in other arrangements to mount different types of equipment to the same deposition chamber 1, for example:
▪ Two or more metal filtered arc ion source of the same type, for faster and/or more homogeneous deposition of metal coating;
▪ Two or more metal filtered arc ion source of different types, for coating parts with two layers of different metals.
▪ Two or more laser ablation sources of the same type, for faster or more homogeneous deposition of material (such as Carbon) with this process.
▪ Two or more laser ablation sources of different types, for coating parts with two layers of different materials.
▪ One or more low energy ion gun 5, for example based on a Hall accelerator, for example in order to polish parts with an ion beam, or in order to harden a surface by ion implantation
▪ One or more magnetron, which can be balanced or unbalanced.
▪ One or more CVD device, such as a plasma enhanced CVD device.
▪ One or more heating or cooling devices.
▪ Or any combinations thereof.

All those equipment have identical flanges and can interchangeably be mounted on any of the different flanges of the apparatus.

In a preferred embodiment, one of the equipment is used for deposition of a sublayer, such as metal layer, while another equipment is used for deposition of an external layer, such as a hard carbon or DLC layer. It is thus possible with a single equipment to deposit various successive layers on a surface of the same part.

A single chamber can thus be proposed or sold with sets comprising various coating equipment that a user can select and mount to the various equivalent positions around the deposition chamber 1, in order to adapt to his needs and to various coating requirements for different pa rts.

Although in most situations the different coating equipment will be used one after the other in order to successively coat superposed layers of coating material on a single part, it is also possible for some processes to use two equipment at the same time, for example two identical equipment in order to fasten the deposition process, or two different equipment in order to mix beams and deposit layers with mixed materials from different sources. Moreover, the different coating equipment could be used in different processes for coating different parts if the parts in the chamber are replaced between uses of each equipment.

According to one aspect of the invention, at least one metal filtered arc ion source 2 comprises two different metal ion sources 28. The use of two sources increases the deposition rate and improves the homogeneity of plasma formed within the deposition chamber 1 when coating parts, resulting in a faster and more regular coating. Each source has one cathode 20 of metal or material that will be used for the coating, and one or several anodes 21 to create an electric arc discharge when at least one current source is activated, so as to extract material from the cathode.

The cathodes have preferably a conical shape in order to homogenise deposition during service time. When the surface cathode is eroded so that its distance to the target increases, its surface is increased due to the conical shape, so that the deposition rate remains approximately constant.

A deflecting system comprises two coils 23, 24 surrounding a portion of a duct just after the cathode 20. Those coils 23, 24 are used to focus the flow of particles extracted from the cathode 20 along an axis 200 of the cathode 20, and to reduce dispersion against side walls of the duct.

The axis 200 of each cathode 20 makes an angle α with the axis 100 of introduction into the deposition chamber 1, which is also the central axis of the flange 10. The emitted beam of particles therefore needs to be deflected from the initial emission direction 100 to the direction of introduction into the deposition chamber 1. This deflection is produced by at least one first deflecting coil 27, which is mounted around the connecting flange 10, so as to be crossed by the deflected beam just before its introduction into the deposition chamber 1. Another optional coil 25 which is provided behind the metal ion sources 28 cooperate with the coil 27 for deflecting said metal ion beam toward said deposition chamber. Those coils 25 and 27 preferably each have a cylindrical or toroidal shape with an axis corresponding to the axis of the connecting flange 10 and to the axis of introduction 100. This deflection acts as a filtering means for filtering neutral particles from particles with weight different from the average of desired weight, which are not deflected respectively in a different direction. A metal trap 29 crossed by the beam is maintained at a varying potential for trapping ions with a different weight. A second coil 26 is preferably arranged close and parallel to the first coil 27, to be crossed by the deflected beam. This second coil cooperates with another coil 38 on the other side of the deposition chamber, to control and homogenise the cloud of particles produced by the arc ion source 2 or by the laser ablation source 3 within the deposition chamber. The above-mentioned coils have the function of bending and focusing the beam of carbon on the desired target, while at the same time suppressing the macro particles, (carbon clusters). Their action may be complemented by that of an electrostatic deflector with flowing potential. It has been found that combination of a source followed by a magnetic and/or electrostatic macroparticles filter, provides a coating of superior smoothness.

The angle α is preferably lower than 135°, even preferably lower than 120°, to provide enough deflection and enough filtering. However, according to an aspect of the invention independent from all other aspects, this angle is also greater than 90°, preferably greater than 95°, to avoid a situation where the axis 200 of both metal filtered arc ion source 2 are aligned and in which the beam produced by one source would be directed toward the other source. This specific arrangement avoids the need for any shield or baffle element at the intersection between the two beams, thus resulting in a simpler and more compact design, which is also easier to clean. Moreover, since the beams are not aligned, this setting improves the mixing and the spatial diffusion of the two beams, thus resulting in a more homogeneous distribution of the particles within the chamber 1.

In a preferred embodiment, the axis 200 of the two metal ion sources 28 are not in a same plane, but in two parallel or non-parallel planes, so that the two beams from the sources 28 are introduced in the deposition camber 1 along a common duct but along two distinct directions. This is useful for improving the distribution of the particles in a direction perpendicular to the plane of the figure, and improving homogeneity of plasma formed within the deposition chamber 1 when coating, thus resulting in an improved coating quality.

In one embodiment, the coating equipment comprises two pairs of metal ion sources 28 superposed over each other, thus providing even faster coating, and/or successive replacement of the different cathodes without complete interruption of the coating process.

The current generator that drives the two metal ion sources 28 preferably generates a pulsed current with a frequency comprised between 1 and 100 Hz, substantially lower than the frequency of 1'000 Hz and more used in conventional metal ions sources. In a preferred embodiment, the current delivered to the second ion source 28 is dephased with respect to the current delivered to the first ion source 28, thus resulting in less perturbations to the electric network system, and more continuous flow of particles into the deposition chamber 1. Each pulse has preferably an energy of 150mJ, or more. Each current pulse is preferably higher than 4'000 A, thus is substantially more than the conventional currents of about 1'000 A used in conventional systems. Test and experiments have shown that this high current, although requiring more complicated electronics, provide for an improved and more regular coating of the parts.

A gas inlet (not represented in the drawings) may be placed near to the metal ion source or sources. Preferably, the gas inlet inject nitrogen, or another inert gas. It has been found that the injection of an inert gas is beneficial and improves the adhesion and compactness of the deposited layers.

The apparatus illustrated in the figure further comprises a pulsed laser ablation source 3 mounted to the deposition chamber 1 over a second connecting flange 10 which is identical or compatible with the first connecting flange 10 to which the ion source 2 is connected. The pulsed laser ablation source 3 is suitable for ablating a target 32, such as a graphite or carbon target. This pulsed laser ablation source 3 is useful due to its ability to produce high purity films, such as diamond-like coatings (DLC) for example. A laser source 30 generates a pulsed laser beam 300 that is directed via a window 37 to a carbon target 32. A focusing lens (not shown) may be used to focus the laser beam.

The laser beam reaches the cylindrical target 32 at a substantial tangential angle, so that carbon ions that instantly evaporate from the target 32 are projected in directions different from the originating direction of the laser. This is useful for preventing deposition of carbon on the window 37. In a preferred embodiment, the laser beam 300 thus makes an angle lower than 45°, preferably lower than 20°, with a tangent of the target 32. A moving mirror 31, controlled by a step motor 34, is preferably controlled in order to deflect the laser beam at the desired location of the target 32.

A first motor 33 is used for rotating the cylindrical target 32 continuously, or in successive steps. The second motor 34 is used for moving the mirror 32 relative to the target along the axis of the cylindrical target 32, so as to change the longitudinal portion of the cylinder which is ablated. Both motors 33, 34 are controlled to produce a regular ablation of the whole surface of the target 32. An additional motor can optionally be used for moving the target 32 relatively to the laser in a direction perpendicular to the incoming laser beam, thus insuring the laser beam always reaches the surface of the target 32. In an option, this displacement for compensating the reduction in diameter of the target is done manually.

In one embodiment, two lasers 30 are provided within the same pulsed laser ablation source 3, and are used for simultaneously attacking the same carbon target 32, or two different targets 32, thus resulting in faster ablation and faster coating.

The flow of particles ablated from the target 32 is directed to a bended duct that links it to the deposition chamber 1, and deflected within this duct using a deflecting coil 38 crossed by the beam of particles, as already mentioned. It has been found advantageous mounting the coil 38 is preferably on a movable support, such that it can be , so that it can be rotated and displaced along the duct in order to control the deflection angle. These displacements can be automatic or manual, insofar as they do not require frequent adjustments.

The magnetic coils provide a considerable reduction of macroparticles, (droplets, carbon clusters). Preferably, their action is be complemented by the electrostatic deflector 29 to provide a Ta-C coating of superior smoothness.

Coils 26 and 38 are preferably in, or close to, the Helmholtz configuration, and have an equal diameter sensibly equal to their mutual distance, generating a uniform field in the deposition chamber 1.The coils provide a magnetic field that optimizes the transport of ions in a plasma channel from the cathode 32 to the deposition chamber 1. The transport of plasma ions in presence of electrons occurs along the magnetic lines starting from the surface of the cathode 32. The conductivity of the plasma along the channel exceeds considerably the conductivity in the radial direction, and equipotential lines with the cathode potential are formed along the magnetic lines of force. At the same time, the magnetic deflection provides filter of particle clusters and macroparticles, with a considerable improvement of the surface finish.

Several factors can affect the transport of ions in the deposition chamber including: diffuse losses - the escape of particles to wall across the magnetic field; drift losses - caused by the shift in the direction of the curvature radius vector; reflections at narrowing of the magnetic field lines of the magnetic field H, and losses associated with the crossing of the walls of the plasma duct and its structural elements by the magnetic lines of force. For an optimal control of these, the multi-coil arrangement described below has proved effective.

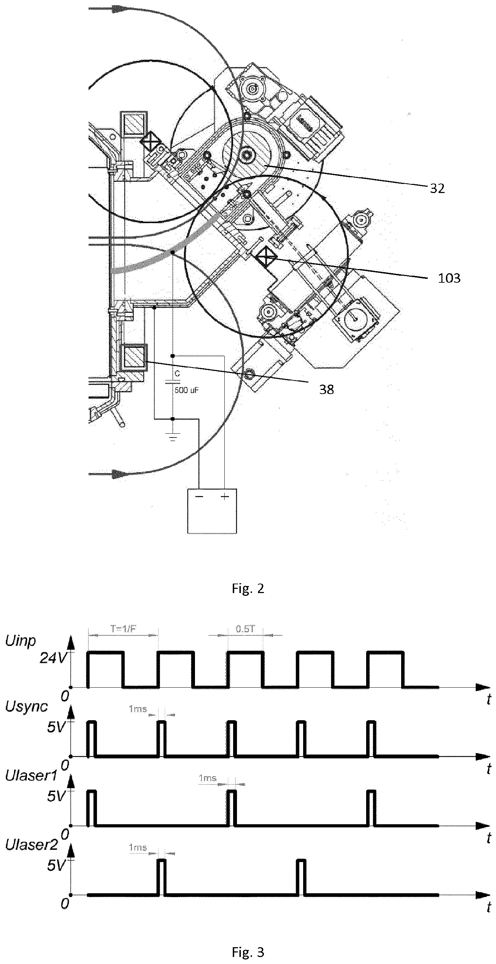

Preferably, a third coil 103 (visible in figure 2) is arranged between the graphite cathode 32 and the trap 35, in order to deviate and focus the positive ions from the cathode into the trap. Importantly, the third coil is not parallel to the first and second coil, and concentrates the ions at a point sensibly close to the entry port of the trap 35. Thanks to this feature, the transport of the ions through the trap is optimised, while the rejection of ions clusters and droplets remains remarkably high. Figure 2 illustrates this aspect of the invention.

The current flowing in the deflection coils is balanced in order to obtain a distribution of the magnetic field close to ideal, i.e., The lines of the magnetic field crossing the surface of the cathode enter the chamber without crossing the walls and other constructional elements of the plasma duct in its path at a level of magnetic induction in the centre of the plasma duct 10-20 mT. To eliminate the parasitic magnetic field, one-turn compensation coils can be used and/or the design of the anode 36 can be adapted. According to another, possibly independent, aspect of the invention, the substrate is connected to a pulsed bias source. Preferably, the output parameters of the output bias source (voltage pulse height, width, repetition rate, frequency, duty-cycle) are determined by an automatic controller, based on the instantaneous value of the coating thickness.

It has been found that the finals surface smoothness can be improved by bombarding the targets with low-energy ions, preferably with energies comprised between 10 and 300V. In a possible variant, the apparatus of the invention comprises a low-energy ion gun for bombarding the substrates with a beam of ions of energy in the 10V-300V range, prior, and/or during and/or after the deposition.

One or more anode electrodes 36 are placed peripherally outside the spinning cylindrical target 32, in the general direction of the deposition chamber 1. The anode is held at a voltage level of 100-1000 V relative to the surface of cylinder 32, for example 200 V negative. The electric field between the anode and the surface of the cylinder supplies a powerful electrical discharge when the laser beam impinges on the cylinder, which determine an avalanche multiplication of the emitted carbon ion. The source can thus be termed a filtered arc carbon source with laser ignition.

A capacitor bank, or another suitable source of pulsed current, is used to maintain the current at a desired level. Current levels vary according to cylinder's size and are preferably between 5000 A and 10000 A for one meter-high cylinder The voltage of the fully charged capacitor bank does not exceed 300 V, and the energy of each pulse may be of about 120 J. The discharge repetition rate, or frequency is between 20 and 50 Hz.

Increasing the laser frequency can increase ta-C deposition rate. Preferably, the invention uses two or more laser timed in interleaved manner, to obtain the desired repetition rate, as shown in figure 3.

The bending angle within the duct is preferably comprised between 30° and 60°, and is preferably 45°, in order to provide for moderated filtering and keeping some of the larger carbon particles within the bended beam, thus resulting in faster and better coating than if a more bended or even a double bended duct is used. An electrostatic deflector, or trap 35 is placed downstream of the anode, in the bent duct to capture particles with excessive weight, for example carbon clusters, as they travel along the duct.

The electrostatic deflector 35 can be left floating, in which case it will spontaneously drift to an electric potential very close to that of the anode, or tied to the anode potential, preferably by a filtering network that provides stabilization. Figure 2 illustrates a possible electric connection.

A potential shift of the ion trap it has been found advantageous to optimize the ion transport. This is in relation with the distribution of the electric potential over the cross section of the plasma flow. The initial concept implies the formation of monotonic equipotentials connecting the volume of the working chamber and the near-cathode region of the plasma. In a classical plasma duct, the inner walls are parallel to the magnetic field lines and equipotential lines, the presence of a floating or forced electric wall displacement does not distort the overall picture of the location of the magnetic power tubes. In the case of the inventive device, we have a developed internal surface of the plasma duct with sharp and significant changes in the relative coordinates of the points on the surface. In this case, the monotonicity of equipotentials is violated, a potential barrier appears in the zone of the outer surface of the anode (in the direction of flow), which leads to growth of both diffuse and drift losses in the plasma flow.

To remediate the described problem, it is possible to apply an "artificial wall" starting in the immediate vicinity of the. This wall may have a floating potential or be forced electrically displaced with respect to the plasma potential. A number of works show that it is sufficient to place one wall in the plasma duct - along the external radius of rotation of the plasma flow. The necessity of forced displacement arises when there is insufficient magnetization of electrons in the plasma flow-that is, In those boundary conditions that are characteristic for the case under consideration. The optimal value of the displacement is determined by the cathode material, the discharge current and the magnetic field strength in the plasma duct.

The power supply is capable of shifting the potential of the electrostatic trap by about 50-60 V positive relative to the anode, which is typically held at the same surface as the outer vessel. The value can be adjusted smoothly, for example between 0 and 100 V. The connection is between a power resistor of suitable value, for example 100 Ohms, to filter the voltage which would otherwise vary widely during a pulsed discharge.

The introduction of the displaced wall will prevent the losses of the plasma flow caused by the inhomogeneity of the potential distribution in the region of the outer edge of the anode, and also allow to regulate the degree of ionization of the plasma at the outlet from the plasma duct. The last assumption is due to the fact that the highly ionized plasma takes place between the cathode and the anode of the source. As the anode is cut off from the cut, the degree of ionization of the plasma decreases due to diffuse and drift losses of the plasma flow, as well as ion recombination in the flow. The displacement of the wall relative to the potential of the plasma makes it possible to select certain charge carriers, stimulating ionization processes in the wall layer of the plasma (several Debye radii). In this case, the integral quasi-neutrality of the plasma is preserved and the ability to control the plasma flow by means of an external magnetic field. As a result, the output of the plasma duct retains a high degree of ionization of the plasma flow, which is necessary to ensure intensive condensation and sub-implantation processes with the growth of the film on the surface of the substrate.

Figure 4?? plots the time evolution of a typical discharge. The width of the laser pulse may be of 20 µs, as plotted, and is typically between 5 and 50 µs. The discharge current, triggered by the laser and sustained by capacitor bank lasts considerably more, and extinguishes when the cathode voltage Vk-Va has fall below a minimum value. The repetition rate may be of about 30 Hz and, is not appreciable at the scale of this plot.

Since the arc discharge in the source is of a pulsed nature and is characterized by large discharge current and released energy, it is proposed to apply a battery of electric capacitors in the electric wall bias circuit and use a linear power source to charge it. The use of such a battery will make it possible to keep the bias potential more or less unchanged during an arc discharge characterized by high discharge current (up to 9000 A), and, consequently, large values of its ionic and electronic components (about 900 A for the ionic component). Preferably, its capacity should be at least 50% of the capacity of the main-drive.

According to another aspect of the invention, the window 37 is a rectangular optical glass window whose major axis is essentially parallel to the rotation axis of the cylindrical target The sliding mirror 31 is actuated in such a way that the laser beam sweeps axially the window, for example along a line parallel to its long sides, and impinges on the target. It has been found that a combination of operational parameters that includes a pulse repetition frequency between 20 and 50 Hz and a pulse current between 5000 and 800 A is advantageous in that the scan line on the inner side of the glass is self-cleaned by the laser beam, and fouling does not accumulate along the line.

The method also relates to a method of fabricating a coated part starting from a non coated part, said method using a plurality of coating equipment around a common deposition chamber, wherein said deposition chamber comprises a plurality of equivalents flanges and wherein the method comprising mounting a metal filtered arc ion source to any one of said flange, mounting a laser ablation source to any other said flange, and successively depositing different layers of different coating materials to parts within said deposition chamber. This method, and the use of the new metal filtered ion source and laser ablation source as described above, results in the manufacturing of new parts having coating properties never reached before, especially in term of purity and regularity.

### List of parts

- 1: deposition chamber
- 2 1st: coating equipment: metal filtered arc ion source
- 3: 2nd coating equipment: laser ablation source
- 5: ion gun
- 10: connecting flanges
- 20: cathode
- 21: anode
- 28: metal ion source
- 23 , 24: focusing coils
- 25 , 27: deflecting coils
- 29: metal trap
- 30: laser
- 31: mirror
- 32: target (such as carbon target)
- 33: first motor
- 34: second motor
- 35: trap
- 36: anode
- 37: window
- 38 , 39: deflecting coils
- 100: axis of introduction into deposition chamber
- 200: axis of the cathode
- 300: laser beam

## Claims

1. An apparatus for coating parts, comprising a deposition chamber (1) and a plurality of coating equipment (2, 3) for simultaneously or successively providing coating materials to said deposition chamber (1), wherein at least one of said coating equipment is an arc carbon source with laser ignition followed by a magnetic and electrostatic macroparticle filter, **characterized in that** at least two of said coating equipment (2, 3) are removably connected to said deposition chamber (1) via connecting flanges (10).
The apparatus of the preceding claim, wherein at least one of said coating equipment (2) is a metal filtered arc ion source (2) followed by a magnetic and/or electrostatic macroparticle filter, wherein at least two of said flanges (10) are identical, so that one said coating equipment (2, 3) can be connected via different flanges (10) to said deposition chamber (10).

2. The apparatus of any one of the preceding claims, wherein said a filtered arc carbon source with laser ignition is followed by a magnetic and electrostatic macroparticles filter including a pair electromagnetic coils on opposite sides of the deposition chamber, a third coil between the arc carbon source and one of the coils of the pair of electromagnetic coils, at an angle with the pair of electromagnetic coils, and an electrostatic deflector.

3. The apparatus of any one of the preceding claims, wherein said laser ablation source (3) comprises a laser (30), a mirror (31) for deflecting the laser beam produced by said laser toward a target (32), a first motor (33) for rotating said target, and a second motor (34) for displacing said mirror so as to ablate different portions of said target.

4. The apparatus of the preceding claim, wherein said laser beam (300) makes an angle lower than 45° with a tangent of said target (32).

5. The apparatus of one of claims 4 to 5, further comprising a third motor for displacing said target relatively to said laser beam along an axis parallel to a rotation axis of the target.

6. The apparatus of any one of the preceding claims, wherein said laser ablation source comprises two lasers (30) operating in interleaved mode for ablating one or more targets.

7. The apparatus of any one of the preceding claims, comprising a self-cleaning window allowing a laser beam to impinge on said filtered arc carbon source (3) with laser ignition.

8. The apparatus of any one of the preceding claims, wherein the magnetic separator includes a bend of approximately 45°.

9. The apparatus of any one of the preceding claims, wherein the cathode current per discharge is comprised between 4000A and 10000A, the cathode potential relative to the anode is comprised between 100 and 500 V.

10. The apparatus of any one of the preceding claims, wherein the electrostatic trap is held at positive potential relative to the anode.

11. The apparatus of any one of the preceding claims, including an artificial wall electrically displaced relative to the plasma potential.
